(19) Europäisches Patentamt
European Patent Office
Office européen des brevets

(11) Publication number: 0 126 803
A2

# (12) EUROPEAN PATENT APPLICATION

(21) Application number: 83111643.9

(22) Date of filing: 22.11.83

(51) Int. Cl.³: C 01 B 33/12
B 01 J 19/12, H 01 L 39/24

(30) Priority: 09.12.82 US 448127

(43) Date of publication of application:
05.12.84 Bulletin 84/49

(84) Designated Contracting States:
DE FR GB IT

(71) Applicant: International Business Machines Corporation
Old Orchard Road
Armonk, N.Y. 10504(US)

(72) Inventor: Blum, Samuel Emil
18-1 Grenada Crescent
White Plains, N.Y. 10603(US)

(72) Inventor: Brown, Karen Hill
2508 Dunning Drive
Yorktown Heights, N.Y. 10598(US)

(72) Inventor: Srinivasan, Rangaswamy
98 Cedar Lane
Ossining New York 10562(US)

(74) Representative: Schröder, Otto, Dr. Ing. et al,
Säumerstrasse 4
CH-8803 Rüschlikon(CH)

## (54) Method for photochemical conversion of silicon monoxide to silicon dioxide.

(57) SiO can be photochemically converted to $SiO_2$ by irradiation with ultraviolet light of wavelengths less than 220 nm in an atmosphere including oxygen. The irradiation can be pulsed or continuous radiation, and energy fluences of at least about $5mJ/cm^2$ will effect the photochemical reaction. The conversion of SiO to $SiO_2$ can be used to provide an etch-stop in a fabrication process and to provide improved devices and circuits, in technologies such as Josephson and semiconductor device technologies.

FIG. 1

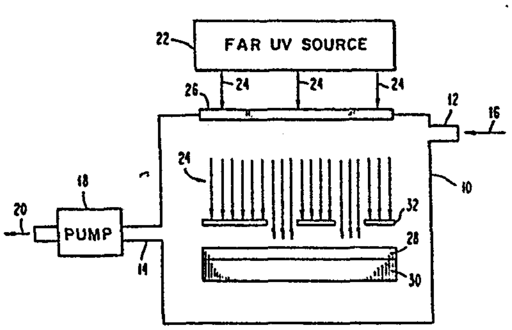


EP 0 126 803 A2

Croydon Printing Company Ltd.

METHOD FOR PHOTOCHEMICAL CONVERSION OF SiO TO $SiO_2$

This invention relates to a method for photochemically converting SiO to $SiO_2$ in an atmosphere containing oxygen. Also disclosed is an apparatus for carrying out the method, the apparatus including a vacuum chamber into which the oxygen containing atmosphere can be introduced.

Oxide insulators are used in many applications, including microelectronic devices and packaging. In particular, SiO and $SiO_2$ are widely used in technology such as semiconductor device technology and Josephson device technology. While both SiO and $SiO_2$ are good insulators, $SiO_2$ is generally preferred because of its inherent stability and good electrical properties. For example, $SiO_2$ is less porous than SiO, and has a lower dielectric constant than SiO. In thin film circuitry where very thin layers are used, the importance of a low dielectric constant becomes even more critical in order to reduce capacitance.

SiO and $SiO_2$ also differ in their abilities to be personalized by etching, and in the techniques in which they are formed. Generally, SiO etches slower than $SiO_2$ when HF is used, and can be formed at a lower temperature. In particular, good films of $SiO_2$ cannot be produced at temperatures less than $400^oC$. This constraint is even more evident when the film has to have a thickness less than 500 nm. However, most technologies would prefer to use fabrication processes wherein the

temperatures required for the different steps of the process are as low as possible. In particular, processes used to make Josephson tunnel devices require temperatures which do not exceed approximately 100°C. In such processes, the superconductive materials are adversely affected if the temperatures used during device and circuit fabrication exceed approximately 100°C.

Even in silicon device processing, it is undesirable to process silicon at high temperatures to produce $SiO_2$, because of the damage which will occur to the silicon layer. Such damage is of particular importance in high density LSI circuits. Consequently, other techniques of forming $SiO_2$ on silicon are being investigated in order to reduce the deposition temperature below about 1000°C, which is commonly used. For example, plasma oxidation of silicon to $SiO_2$ requires a temperature of about 500°C. There is a drawback to this technique though, because the plasma may induce damage in the underlying silicon layer.

Another technique for depositing $SiO_2$ on silicon has utilized a far ultraviolet oxidation method based on the reaction

$$N_2O \xrightarrow[H_g]{UV} O \xrightarrow[Si]{} SiO_2.$$

This method requires mercury vapor in-situ, which is undesirable in silicon device technology.

In processes used to make Josephson device circuits, SiO insulating films are often used, because they can

be deposited at temperatures less than about 100°C. However, SiO is not a preferable material because of its relatively high dielectric constant as compared with that of $SiO_2$, and because SiO is not as easily personalized as $SiO_2$.

Layers of SiO of very high quality having stochiometric ratios of 1:1, Si:O, can be produced using ultra high vacuums (such as vacuums of $10^{-6}$Pa in an evaporation system). Such SiO is quite stable and will show very little change to $SiO_2$ over a period of several years. Of course, if the temperature is increased, thermal oxidation of SiO to $SiO_2$ will proceed rapidly. This is a well known approach for converting SiO to $SiO_2$, but is disadvantageous due to the high processing temperatures that are required.

An example of a technique where ultraviolet irradiation has been used to change the absorbance of silicon oxide films is described in an article "Stress Relief induced in Silicon Oxide Films by Ultraviolet Radiation" by I. J. Hodgkinson et al, Thin Solid Films, 17, pages 185-197 (1973). The wavelength of the ultraviolet light was 254 nm, and different atmospheres were used during irradiation and after irradiation. For short exposure times, the absorption bands were sharpened and increased in height at peaks characteristic of $Si_2O_3$. No absorption band for $SiO_2$ appeared. Only for extended exposures in air, the O:Si ratio approached 2:1, which is what would be expected since $Si_2O_3$ is relatively unstable and will convert to $SiO_2$. The irradiation in this

situation is similar to annealing of silicon oxide films where heat treatment results in the bonding of isolated $SiO_4$ tetrahedra. This process uses up excess silicon, and hence causes changes leading to the more stable form $SiO_2$.

It would be desirable to have a process which would reliably convert SiO and $Si_2O_3$ to $SiO_2$ in a short period of time and in a controlled manner. It would also be desirable to have such conversion be complete, without leaving unbonded Si atoms.

Accordingly, it is a primary object of this invention to provide a reliable technique for converting oxides of silicon to $SiO_2$ at temperatures less than about $100^{o}C$.

It is another object of the present invention to provide the technique for controllably changing oxides of silicon to $SiO_2$ where the technique can be adapted to device manufacturing processing without altering other layers of the device.

It is another object of this invention to provide a technique for converting oxides of silicon, and particularly SiO, to $SiO_2$ in order to change the electrical properties of the oxides.

It is still another object of the present invention to provide a technique for controllably and reliably converting SiO to $SiO_2$ in selected

areas of a layer of SiO.

It is another object of this invention to provide a new technique for materials transformation which is useful in the fabrication of microelectronic devices and circuits.

It is still another object of this invention to provide a process in which a single level of insulation can be produced having localized areas with different electrical properties.

It is still another object of this invention to provide a technique for selectively converting oxides of silicon to $SiO_2$.

It is a further object of this invention to provide a process step which can be used to improve processes for making Josephson device circuits.

It is a further object of this invention to provide a technique in which an etch stop can be formed between two layers of similar material.

It is a further object of this invention to provide a technique for converting a layer of SiO to $SiO_2$, where the conversion can be made to any depth in said layer.

It is a still further object of this invention to provide a technique for making microelectronic structures comprising a plurality of layers, wherein etch-stops are formed during the process.

It is another object of this invention to provide a technique for improved photochemical conversion of SiO to $SiO_2$, in which the ratio Si:O is essentially 1:2.

It is a further object of this invention to provide an improved technique for making devices comprising thin films of SiO and $SiO_2$.

The invention as claimed is intended to meet the above objectives and to remedy the drawbacks hitherto encountered. The proposed method is characterized in that it comprises the step of irradiating the SiO that is to be converted to $SiO_2$ with ultraviolet radiation having wavelengths of less than 220 nm.

The advantages offered by the invention are mainly that it provides a technique for forming $SiO_2$ layers of varying thickness and high quality at low temperatures.

Various ways of carrying out the invention are described in detail below with reference to drawings which illustrate specific embodiments and in which

Fig. 1 is an illustration of an apparatus suitable for the practice of the present invention.

Figs. 2.1 and 2.2 illustrate the effect of ultraviolet irradiation having wavelengths less than 220 nm on a layer of SiO. These are infrared transmission (absorption) plots, Fig. 2.1 being the plot of infrared transmission on a portion

of the SiO layer which has not been irradiated with ultraviolet radiation, while Fig. 2.2 is the infrared transmission plot of the other half of the SiO layer, which has been irradiated. Together, these plots illustrate the shift in infrared transmission due to the conversion of SiO to $SiO_2$.

Fig. 3 is a plot showing the results of a He backscattering experiment that has been used to verify the conversion of SiO to $SiO_2$ by the irradiation of ultraviolet radiation having a wavelength of 193 nm, in the presence of oxygen. The number of counts (i.e., the number of $He^+$ ions reflected from the sample) is plotted against the energy of the backscattered $He^+$ ions, the shift in the curve at approximately 1.2 MeV indicating the conversion of SiO to $SiO_2$.

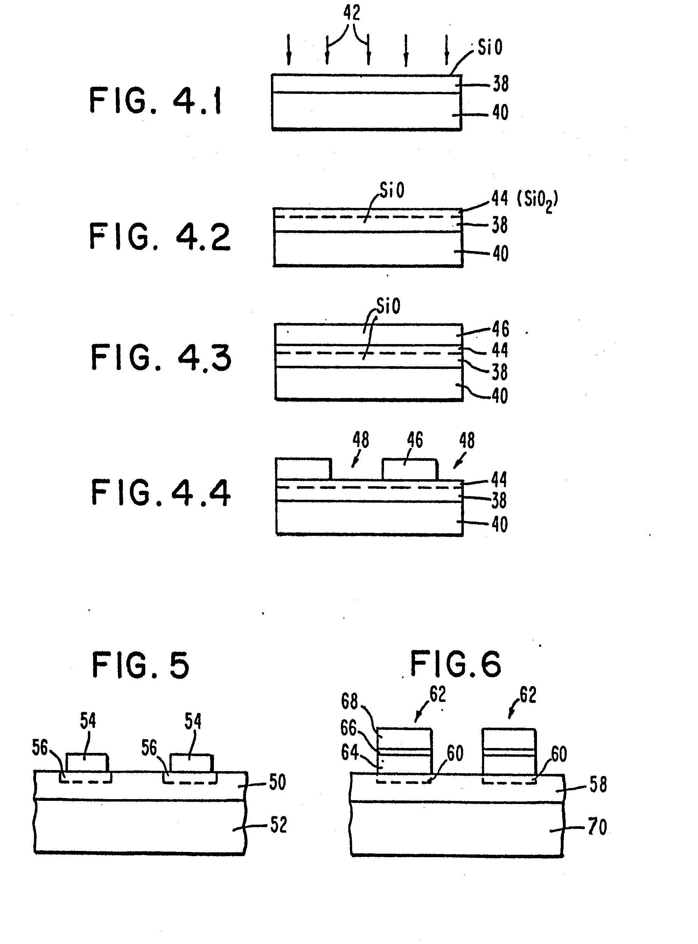

Figs. 4.1 - 4.4 indicate a use of this invention to provide an etch stop in the processing of thin film devices.

Fig. 5 illustrates the use of the invention to provide a circuit structure in which an electrical conductor is located over a portion of an SiO layer which has been converted to $SiO_2$.

Fig. 6 is an illustration of another use of this invention wherein a Josephson effect device is located over a converted portion of a SiO layer, the converted portion being $SiO_2$.

In its broadest sense, this invention describes a method for converting a first oxide species, into

a second oxide species by irradiation of the first oxide species with ultraviolet light of wavelengths less than 220 nm, in an environment including oxygen. More specifically, the invention describes a technique and apparatus for converting SiO to $SiO_2$ by irradiating SiO with ultraviolet radiation of wavelengths less than 220 nm in an environment including oxygen.

The irradiation can be either pulsed radiation or continuous wave radiation, and can be provided by either a lamp or a laser. Generally, the energy fluence in the radiation can be very low, although it is desirable to have sufficient energy fluence to cause a significant photochemical effect to occur. For example, when laser pulses are used, energy fluences of at least about 5 $mJ/cm^2$/pulse will provide effective conversion to $SiO_2$.

The effect which occurs is a photochemical effect in which SiO absorbs light and is photochemically oxidized with oxygen to produce $SiO_2$. The environment has to include oxygen for this conversion, and can be air, pure oxygen, or a mixture of gases including oxygen. Water saturated air, steam, etc. are also suitable in the practice of this invention.

By repeated irradiation of this ultraviolet light in an atmosphere including oxygen, any depth of SiO can be converted to $SiO_2$.

A surface layer of SiO will be converted to $SiO_2$ but, since $SiO_2$ is transparent to wavelengths

less than 200 nm, the effect of further irradiation will not be hindered. In this way, any depth of SiO can be converted to $SiO_2$. Examples will be given showing the total conversion of SiO to $SiO_2$ for several depths, such as depths of 500 nm or greater.

Fig. 1 shows an apparatus which is suitable for carrying out the present invention. The apparatus includes a vacuum chamber 10 having an input port 12 and an output port 14. Gases such as air, water vapor, steam, oxygen, etc. can be introduced into chamber 10 as indicated by arrow 16. The excess gases and volatile byproducts of the reaction can be removed from chamber 10 by using pump 18. The volatile products which are removed are indicated by the arrow 20.

A far UV source 22 is used to produce radiation 24 having wavelengths less than 220 nm. Radiation 24 passes through window 26 and enters chamber 10. Window 26 is typically comprised of a suprasil quartz window, which will block radiation of wavelengths longer than about 220 nm.

The source 22 of ultraviolet radiation of this wavelength range can be one which produces either pulsed or continuous wave radiation. Two suitable examples are ArF excimer lasers producing a pulsed radiation output at 193 nm and a low pressure mercury resonance lamp producing a continuous wave output at 185 nm. The energy fluence available from this laser is greater than

that available from the mercury continuous wave source, and can be used to more quickly convert SiO to $SiO_2$. A suitable ArF laser is one produced by Lambda Physik having Model No. EMG 500. The low pressure mercury resonance lamps are also commercially available.

In addition to these two ultraviolet light sources, any type of source or optical system can be used to produce radiation in the wavelength range less than 220 nm for the purposes of this invention. However, the higher power laser sources are generally more efficient in terms of the time involved to produce the necessary photochemical reaction.

Radiation 24 which enters chamber 10 impinges upon oxide layer 28, located on substrate 30. In the examples to be presented, oxide layer 28 is a layer of SiO, and substrate 30 is any material, including metal, semiconductors, insulators, etc. In FIG. 1, radiation 24 is passed through a mask 32 in order to provide irradiation of selected areas of the SiO film 28. Of course, a blanket irradiation of the entire area of film 28 can also be used. Whether selective area irradiation or blanket irradiation is to be used will depend upon the application of this technique to different processes.

When this short wavelength ultraviolet light strikes SiO in the presence of oxygen, a photochemical reaction occurs in which the SiO absorbs light and is photochemically oxidized by the

oxygen to $SiO_2$. There must be some oxygen present for this reaction to occur, and generally the reaction rates and efficiency increase as the amount of oxygen present increases. As noted, oxygen can be present in many forms, including air, mixtures of gases, water saturated air, steam, and pure oxygen. When a high intensity ultraviolet light source, such as the ArF laser is used, a higher concentration of oxygen is generally needed, since a great number of input photons will be present in the high intensity ultraviolet beam. If oxygen atoms can be provided for every incident photon, the conversion of SiO to $SiO_2$ will proceed rapidly.

The effect is a surface effect in which molecules of SiO on the surface are photochemically changed to $SiO_2$. However, $SiO_2$ is transparent to wavelengths in this range, and the process of conversion can continue through the depth of film 28. The depth of conversion of SiO to $SiO_2$ depends upon the length of time the radiation is applied. Any depth of layer 28 can be converted, including its entire thickness.

As was noted, the pulsed laser sources generally provide greater energy fluences and therefore are more efficient in terms of the time required to convert SiO to $SiO_2$. However, there appears to be no threshold on the energy fluence which must be applied in order to have the conversion occur. Thus, the low pressure mercury lamp can be used effectively for blanket conversion of a thin surface layer of the film 28, in many

processes. The advantage of a laser providing focused pulse radiation is that smaller areas can be illuminated with good localized control and rapid conversion, especially when a significant depth of SiO has to be converted to $SiO_2$.

In the practice of this invention, it has been observed that the quality of the SiO film does not affect the rate or way it is converted photochemically into $SiO_2$. In the experiments to date, high quality SiO was converted into equally high quality $SiO_2$. It also appears that trace amounts of $Si_2O_3$ in the initial SiO film are also converted to $SiO_2$. It is not known at this time whether this technique can be used to produce $SiO_2$ films having better properties than the irradiated SiO films from which they were produced.

The conversion of SiO to $SiO_2$ has been observed to be a complete photochemical conversion, and not just a rearrangement of Si and SiO in the film 28. Experiments have verified this, as indicated by FIGS. 2.1, 2.2, and 3.

FIGS. 2.1 and 2.2 are infrared transmission plots of a sample of SiO, a first portion of which was irradiated with ultraviolet light of wavelengths less than 220 nm in the presence of oxygen, while a second portion thereof was not irradiated.

FIG. 2.1 is a plot of the portion which was not irradiated, while FIG. 2.2 is a plot of a portion of the sample which was irradiated. The sample is a layer of SiO on Si, where the thickness of the

SiO layer was 275 nm. The irradiation was with laser pulses at 193 nm from an ArF excimer laser. 200 pulses (each of approximate pulse width 10 nsec) were applied.

The infrared transmission spectrum was examined from 2.5 μm to 40 μm. As noted from a comparison of FIGS. 2.1 and 2.2, there is a shift in the transmission of the valley 34, corresponding to the oxidation of the irradiated SiO sample to produce $SiO_2$. No peak was seen which would correspond to the presence of Si in the irradiated sample. Thus, there was not merely a rearrangement of atoms within the irradiated sample of the type which would leave free Si and $SiO_2$ (or SiO). Instead, two molecules of SiO combined with one molecule of oxygen to produce two molecules of $SiO_2$.

The precise mechanism for the photochemical conversion of SiO to $SiO_2$ is not presently known. Both SiO and $O_2$ could absorb radiation at about 200 nm to produce excited states. Depending upon the lifetime of the excited states, ample time exists for the diffusion of oxygen to provide $SiO_2$.

FIG. 3 is a plot made in a $He^+$ backscattering experiment. In this experiment, 100 nm of SiO was irradiated in air by ultraviolet radiation produced by an ArF laser (193 nm). 20,000 pulses were used in the irradiation, each of which had a pulse duration of approximately 10 nsec. The energy fluence was about the same as that used in the experiment depicted by FIGS. 2.1 and 2.2 (120 $mJ/cm^2$/pulse).

In FIG. 3, the number of counts of backscattered $He^+$ is plotted against the energy of the backscattered $He^+$. In this type of test, $He^+$ ions are directed to a sample of SiO (solid curve), and are reflected by the sample: After the sample has been irradiated with ultraviolet radiation in accordance with the present invention $He^+$ ions are again directed to the sample and the dashed curve is obtained. The UV irradiation was done in air using 193 nm radiation pulses from an ArF laser. The SiO and $SiO_2$ samples were at a $-70^o$ tilt with respect to the incoming $He^+$ ions. The ions had an input energy of 2.3 MeV and a charge of 80μC.

The backscattering curve for the layer of SiO (prior to UV irradiation) is given by the solid line. The relative composition Si:O of this 100 nm layer of SiO was 49.7:50.3.

After irradiation in air by ultraviolet pulses, the SiO was converted to $SiO_2$ and the backscattering curve shifted, as indicated by the dashed curve. The relative composition Si:O of this converted layer was Si:O = 35.3:64.7.

The fact that $SiO_2$ is obtained as a result of the photochemical reaction is not of itself the final answer. A further examination is made to determine whether or not any free Si is present. If free Si were present, a sharp peak would be obtained in the backscattering curve at an energy corresponding to the free

Si. No such peak is seen.

The results leading to FIG. 3 were obtained by UV irradiation in air. Similar results, indicating the conversion to $SiO_2$, are obtained in other atmospheres including oxygen.

In the samples used for FIGS. 2.1, 2.2 and 3, the substrate was Si, on which the SiO layer was deposited or grown. However, the substrate can be any material. The same photochemical effect will occur and SiO will be photochemically converted to $SiO_2$.

The successful and reliable conversion of SiO to $SiO_2$ is a useful procedure, leading to improved fabrication processes and products. FIGS. 4.1-4.4 illustrate one use of this technique to provide a so-called "etch-stop". Such a stop is used to prevent etching of an underlying layer in order to provide removal or patterning of an overlying layer.

In more detail, FIG. 4.1 shows a layer 38 of SiO on a substrate 40. Layer 38 is given a blanket irradiation by ultraviolet light of wavelengths less than 220 nm, as indicated by the arrows 42. This radiation is applied for only a small amount of time to convert a surface layer 44 of layer 38 to $SiO_2$ (FIG. 4.2).

Another layer 46 of SiO is then deposited over converted $SiO_2$ layer (FIG. 4.3). It is desired to pattern layer 46 by reactive ion etching (RIE).

SiO can be etched by $CF_4$ gas plasmas in reactive ion etching. However, the RIE conditions can be set such that $SiO_2$ will be etched more slowly than SiO. Thus, the $SiO_2$ layer 44 will serve as an etch-stop when layer 46 is patterned. This is indicated in FIG. 4.4 where portions 48 of layer 46 have been removed by RIE which stops at the etch-stop provided by $SiO_2$ layer 44.

The use of etch-stops is dependent upon differential etch rates which exist for different materials. In the fabrication of devices requiring multilevel thin film technology, etch-stops are very useful. However, such stops are usually provided by depositing layers of different composition, which is an additional process constraint requiring different evaporant sources, etc. In the practice of the present invention, multiple layers of the same composition can be deposited and then converted to a different composition.

In the fabrication of circuits using thin film conductors and transmission lines for carrying high speed signals, factors such as the dielectric constant of an insulating layer become particularly important. In FIG= 5, the capacitance of localized areas is tailored by a conversion of the chemical species in those areas. Thus, layer 50 is a layer of SiO located on a substrate 52. Conductors 54 are to be deposited over SiO layer 50. In order to reduce the dielectric constant and therefore the capacitance in the areas where conductors 54 are to be deposited, ultraviolet

irradiation in an oxygen environment is used to convert regions 56 to $SiO_2$. Since the dielectric constant of $SiO_2$ is significantly less than that of SiO, the signal carrying capabilities of the structure of FIG. 5 will be enhanced.

While the regions 56 that are converted to $SiO_2$ are shown as surface regions in FIG. 5, it is understood that these regions can extend throughout the entire depth of layer 50.

In another variation of the embodiment in FIG. 5, it is possible to vary the thickness of the dielectric layer 50 and still achieve small capacitance. For example, layer 50 can be made quite thick but then be converted to $SiO_2$ in order to reduce the dielectric constant beneath the conductors 54. Thicker insulation layers may be required for certain purposes and, since the dielectric constant can be tailored in different locations, the effect of the additional thickness will not be disadvantageous.

FIG. 6 presents another embodiment that is particularly useful in the fabrication of Josephson effect devices and circuits. Here, a layer 58 of SiO is located over the substrate 70. Substrate 70 could be an insulator or a superconducting groundplane. Regions 60 of SiO layer 58 have been converted to $SiO_2$. Josephson effect devices 62 are formed directly over converted layer 60. Devices 62 typically comprise the base superconducting electrode 64, a thin tunnel barrier 66, and a top, or counter-superelectrode 68.

In Josephson device technology, it has been found that tunneling logic gates operate with better performance when they are located on $SiO_2$ rather than SiO. However, $SiO_2$ cannot be obtained in good quality at process temperatures less than about 400°C. Temperatures this high cannot be used in the processes used to make superconducting devices and circuits and, therefore, $SiO_2$ is not used. The invention illustrated by FIG. 6 provides a technique and structure for obtaining better performance from Josephson devices and circuits utilizing those devices.

In FIG. 6, the converted regions 60 are illustrated as being shallow regions of layer 58. In practice, the converted regions can extend completely through layer 58 to the substrate 60. However, it appears that the electrical properties of the Josephson devices built on converted regions extending entirely through layer 58 are better than those where the converted regions 60 are only surface layers of layer 58.

In the practice of this invention, ultraviolet wavelengths less than 220 nm have been used to convert one oxide form (SiO) into another, ($SiO_2$), in the presence of an atmosphere containing oxygen. Although SiO has been shown as a primary example, it also appears that $Si_2O_3$ can be converted to the more stable $SiO_2$. Also, this photochemical conversion can occur at different temperatures, although it will work well at temperatures less than 100°C.

While the invention has been described with respect to specific embodiments, it will be understood by those of skill in the art that variations can be conditions which will be encompassed within the spirit and scope of the present invention.

# CLAIMS

1. Method for photochemical conversion of SiO to $SiO_2$ in an atmosphere containing oxygen, characterized in that it comprises the step of irradiating the SiO (28) with ultraviolet radiation (24) having wavelengths of less than 220 nm.

2. The method of claim 1, wherein the radiation is pulsed radiation.

3. The method of claim 2, wherein the radiation has an energy fluence of at least $5mJ/cm^2$/pulse.

4. The method of claim 1, wherein the pulse width is in the order of 10 nsec.

5. The method of claim 1, wherein the radiation is continuous waveform radiation.

6. The method of claim 1, wherein the radiation is produced by a laser.

7. The method of claim 1, wherein the conversion occurs at temperatures less than $100^oC$.

8. The method of claim 1, wherein the conversion occurs at room temperature.

9. The method of claim 1, wherein the atmosphere is selected from one of the following: pure oxygen, air, steam, mixtures of oxygen and other gases, and water saturated air.

10. The method of claim 1, wherein the SiO is in the form of a layer deposited on a substrate.

11. The method of claim 10, wherein the layer is irradiated for a sufficient amount of time to convert the entire thickness of the SiO layer to $SiO_2$.

12. The method of claim 10, wherein less than the entire thickness (44) of the SiO layer (38) is converted to $SiO_2$.

13. The method of claim 10, wherein the layer of SiO (50) is irradiated in selected areas thereof thereby forming restricted converted regions (56).

14. The method of claim 10, wherein the layer of SiO is located on a substrate including a metallic layer.

15. The method of claim 10, wherein the layer of SiO is located on a substrate including a semiconducting material layer.

16. Apparatus for carrying out the method of claim 1, including a vacuum chamber into which the oxygen containing atmosphere can be introduced, characterized in that it comprises a source (22) for providing the ultraviolet radiation (24), and a window (26) through which the radiation can enter the chamber, the window being comprised of a material that will block radiation of wavelengths longer than about 220 nm.

FIG. 1

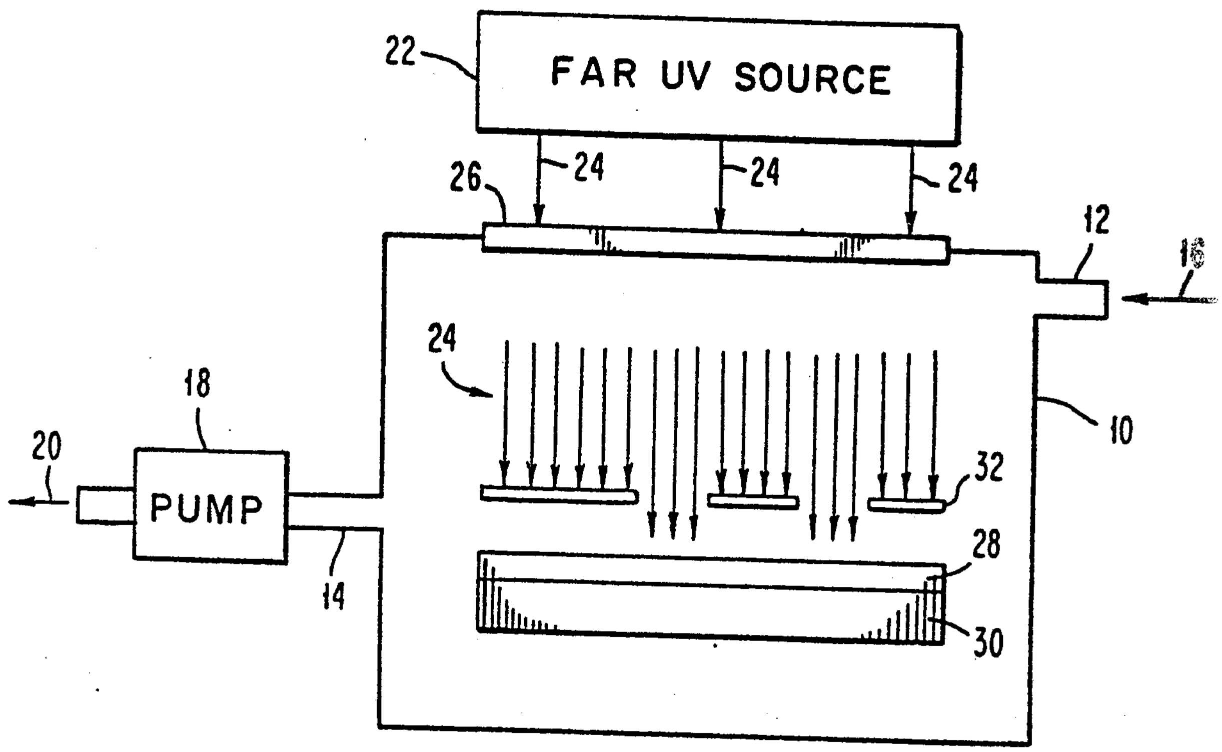

FIG. 2.1

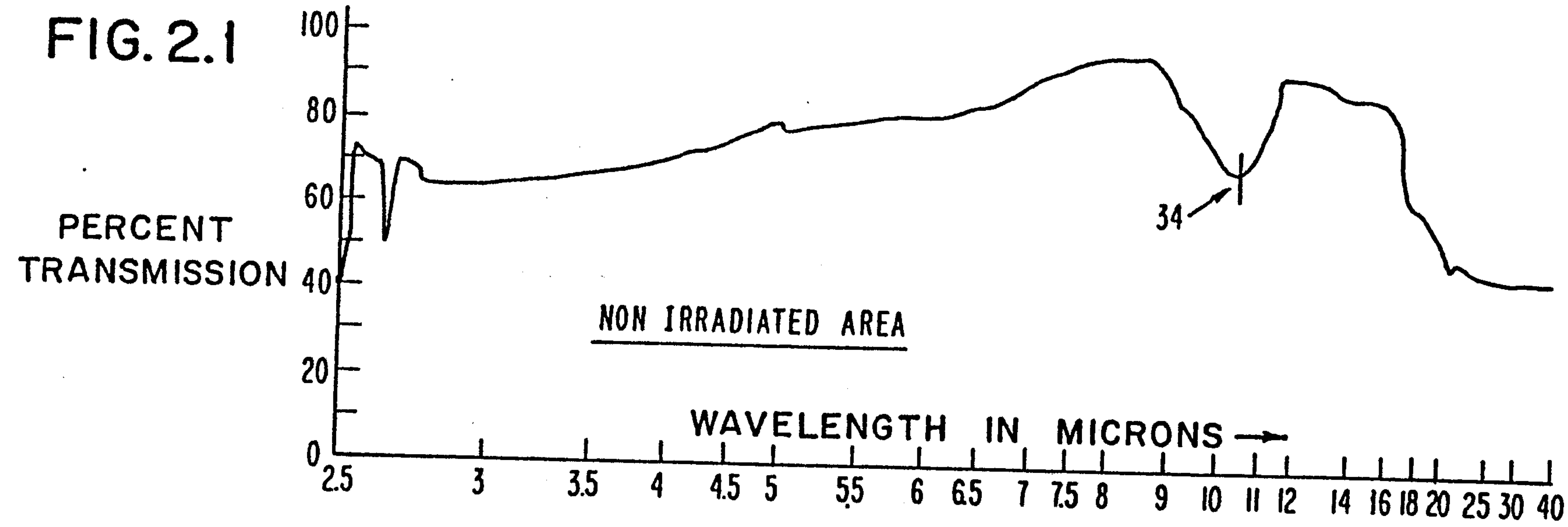
PERCENT TRANSMISSION
100
80
60
40
20
0
NON IRRADIATED AREA
34
WAVELENGTH IN MICRONS
2.5
3
3.5
4
4.5
5
5.5
6
6.5
7
7.5
8
9
10
11
12
14
16
18
20
25
30
40

FIG. 2.2

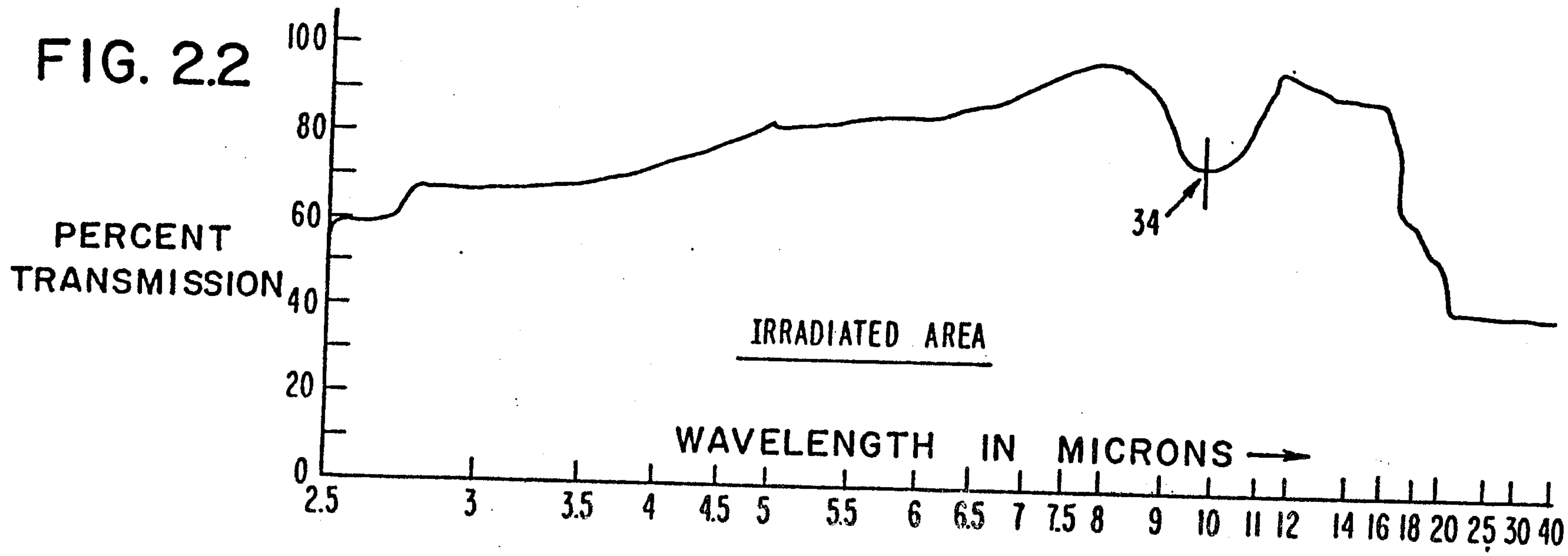
PERCENT TRANSMISSION
100
80
60
40
20
0
IRRADIATED AREA
34
WAVELENGTH IN MICRONS
2.5
3
3.5
4
4.5
5
5.5
6
6.5
7
7.5
8
9
10
11
12
14
16
18
20
25
30
40

FIG. 3

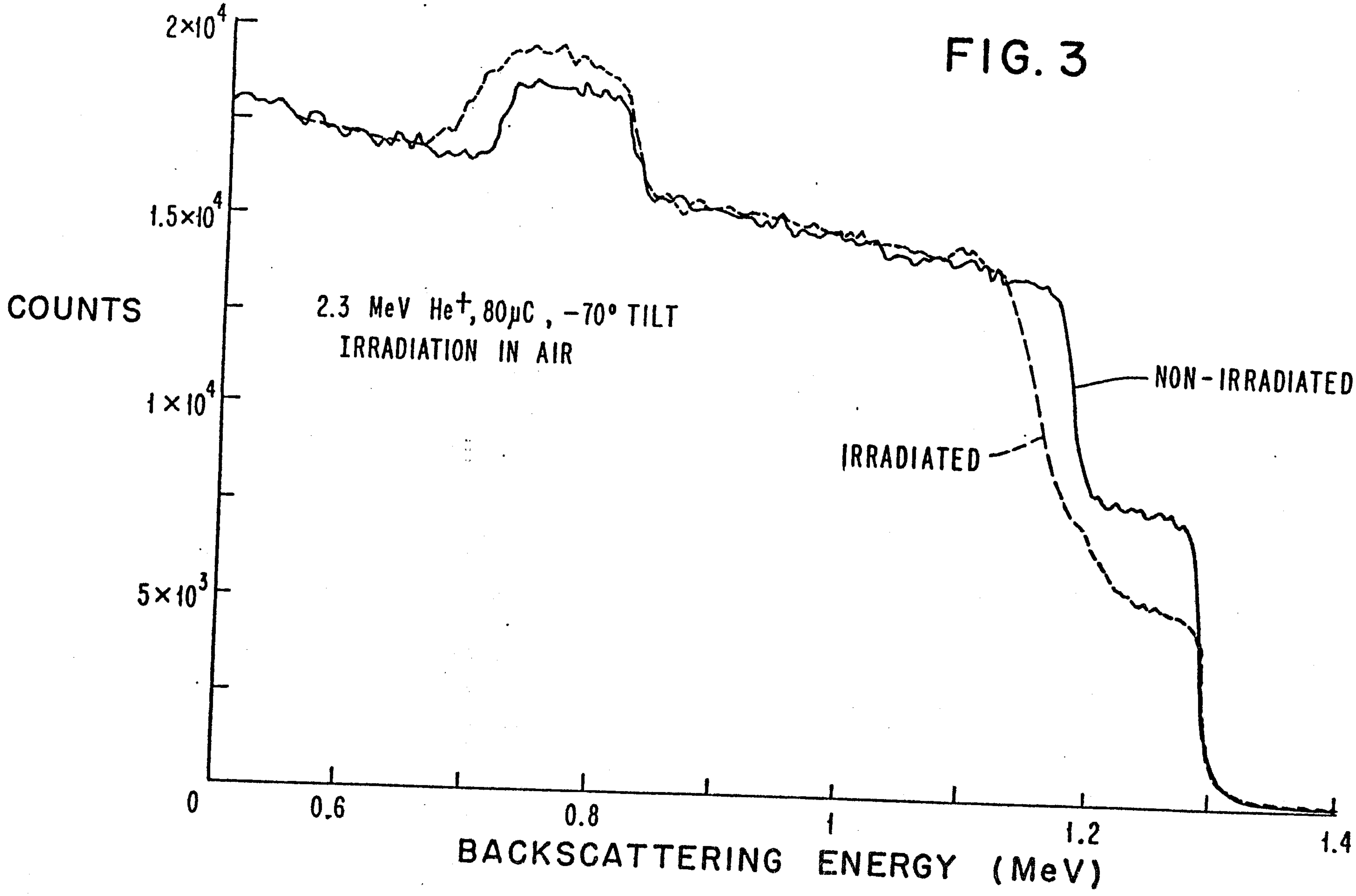
2×10^4
1.5×10^4
1×10^4
5×10^3
0
COUNTS
2.3 MeV He+, 80μC, −70° TILT
IRRADIATION IN AIR
NON-IRRADIATED
IRRADIATED
0.6
0.8
1
1.2
1.4
BACKSCATTERING ENERGY (MeV)

FIG. 4.1

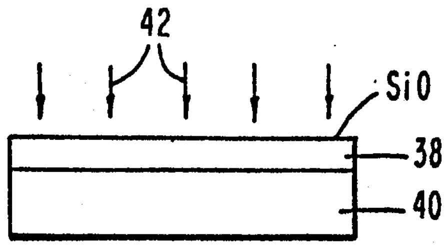


FIG. 4.2

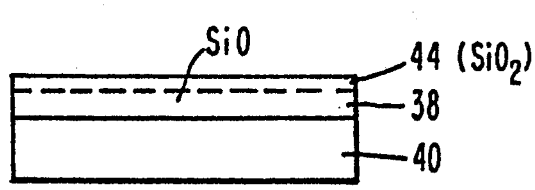


FIG. 4.3

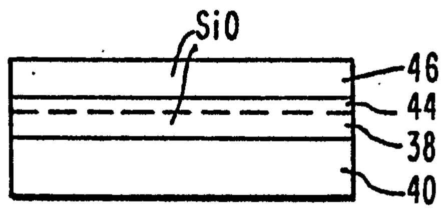


FIG. 4.4

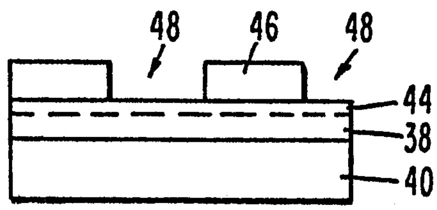


FIG. 5

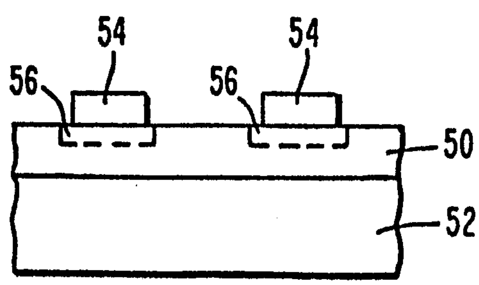


FIG. 6